# EUROPÄISCHE PATENTSCHRIFT

(11) **EP 1 273 027 B1**
(45) Veröffentlichungstag und Bekanntmachung des Hinweises auf die Patenterteilung: **07.02.2007**
(21) Anmeldenummer: 01933607.2
(22) Anmeldetag: 12.04.2001
(51) Int. Cl.: H01J 37/32

(54) **REAKTIONSKAMMER MIT WENIGSTENS EINER HF-DURCHFÜHRUNG**
REACTION CHAMBER WITH AT LEAST ONE HF FEEDTHROUGH
CHAMBRE DE REACTION DOTEE D'AU MOINS UNE OUVERTURE POUR LIGNE H.F.

(30) Priorität: 12.04.2000 DE 10018127
(43) Veröffentlichungstag der Anmeldung: 08.01.2003
(73) Patentinhaber: Aixtron AG, 52072 Aachen (DE)
(72) Erfinder: FRANKEN, Walter, 52249 Eschweiler (DE); STRAUCH, Gerd, 52072 Aachen (DE); KÄPPELER, Johannes, 52146 Würselen (DE); JÜRGENSEN, Holger, 52072 Aachen (DE)
(74) Vertreter: Grundmann, Dirk
(86) Internationale Anmeldenummer: PCT/DE2001/001450
(87) Internationale Veröffentlichungsnummer: WO 2001/078105

(56) Entgegenhaltungen:
- EP-A- 0 109 808
- WO-A-00/22646
- WO-A-97/42648
- FR-A- 852 026

## Beschreibung

### Technisches Gebiet

Die Erfindung bezieht sich auf eine Reaktionskammer insbesondere für die Durchführung von Verfahren zur Beschichtung von Substraten, wie CVD-Verfahren, gemäß dem Oberbegriff des Patentanspruchs 1.

Reaktionskammern, wie sie im Oberbegriff des Patentanspruchs 1 vorausgesetzt sind, werden beispielsweise für die Herstellung von III-V oder II-VI-Halbleiterschichten, Supraleitern oder sonstigen Schichten auf beliebigen Substraten, wie Silizium oder SiC z.B. mittels CVD-Verfahren verwendet. Zu Anwendungsmöglichkeiten gattungsgemäßer Reaktionskammern über die vorstehend beispielhaft genannten, nicht abschließend aufgezählten Möglichkeiten hinaus wird auf bekannte Reaktionskammern verwiesen, wie sie aus der Patentliteratur bekannt sind und/oder beispielsweise von der Anmelderin dieser Anmeldung, der Aixtron AG, Aachen, DE serienmäßig hergestellt und angeboten werden.

Bei einer Vielzahl von Anwendungen werden zur Beheizung der Substrate und/oder sonstiger Elemente der Reaktionskammer induktive Heizungen oder Widerstandsheizungen verwendet. Zur Speisung der Induktionsspulen oder anderer in der Reaktionskammer angeordneter elektrischer Elemente für Heizungen, Sensoren oder Steuereinrichtungen ist es erforderlich, elektrische Durchführungen und insbesondere HF- bzw. RF (Radiofrequenz)-Durchführungen vorzusehen.

### Stand der Technik

Üblicherweise sind die Durchführungen und insbesondere die HF- bzw. RF-Durchführungen in Durchbrüche eingesetzt, die in der Außenwand der Reaktionskammer vorgesehen sind. Selbstverständlich ist es erforderlich, daß die Durchführung derart in den jeweiligen Durchbruch eingesetzt ist, daß die Reaktionskammer gegenüber dem Außenraum vakuum- bzw. druckdicht abgedichtet bleibt.

Aus der Patentliteratur sind die verschiedensten Ausführungsformen für vakuum- bzw. druckdichte HF- bzw. RF-Durchführungen bekannt, als Beispiel sei die Druckschrift EP 0 109 808 genannt. Weiterhin werden von den einschlägigen Herstellern die unterschiedlichsten Durchführungen für Vakuum-Rezipienten oder dgl. angeboten.

Die bekannten Durchführungen sind jedoch im Hinblick auf die nachstehend genannten Anforderungen, wie sie gerade bei Reaktionskammern für die einleitend genannten Anwendungen auftreten, nicht optimal bzw. gehen einen Kompromiß bezüglich der Gesamtheit der nachstehenden Anforderungen ein:
1. HF-Durchführungen sollten unempfindlich gegen Schläge und Stöße sein, und insbesondere nicht durch Schläge oder Stöße, wie sie gerade beim Arbeiten in Reaktionskammern auftreten können, undicht werden.
2. HF-Durchführungen sollten insbesondere dann, wenn sie hohe elektrische Leistungen in den Innenraum der Reaktionskammer leiten sollen, mit Wasser kühlbar sein, ohne daß es zu Überschlägen auf die Kammerwand oder sonstige Teile der Reaktionskammer kommt.
3. HF-Durchführungen sollten leicht auswechselbar sein, wobei gegebenenfalls defekte Teile leicht ersetzbar sein sollten.
4. HF-Durchführungen sollten zudem kostengünstig herstellbar sein.

### Darstellung der Erfindung

Der Erfindung liegt die Aufgabe zugrunde, eine Reaktionskammer mit wenigstens einer elektrischen Durchführung und insbesondere einer HF-Durchführung anzugeben, bei der die kostengünstig herzustellende Durchführung leicht eingebaut werden kann, die Durchführung Stöße bzw. Schläge "verkraftet", ohne beschädigt und insbesondere undicht zu werden, und gegebenenfalls defekte Teile der Durchführung einzeln ersetzt werden können.

Eine erfindungsgemäße Lösung dieser Aufgabe ist im Patentanspruch 1 angegeben. Weiterbildungen der Erfindung sind Gegenstand der Ansprüche 2 folgende.

Die Erfindung zeichnet sich durch die Kombination folgender Merkmale aus:
- in jeden Durchbruch ist eine Trägerplatte dichtend eingesetzt,
- die Trägerplatte weist wenigstens einen Durchbruch für eine HF-Leitung auf,
- jede HF-Leitung weist an ihrem in der Reaktionskammer angeordneten Bereich einen Kragen auf, an dem eine erste Dichtung vorgesehen ist,
- zwischen eine zweite Dichtung an der Trägerplatte und die erste Dichtung an dem Kragen ist eine erste Scheibe aus einem isolierenden Material eingesetzt,
- an dem außerhalb der Reaktionskammer angeordneten Bereich jeder HF-Leitung ist ein Gewinde vorgesehen, auf das ein Schraubelement derart aufgeschraubt ist, daß es den Kragen der HF-Leitung über die erste Dichtung an der isolierenden Scheibe und diese über die zweite Dichtung an der Trägerplatte dichtend in Anlage hält, ohne daß ein elektrischer Kontakt zwischen HF-Leitung und Trägerplatte besteht bzw. ein Überschlag zwischen der HF-Leitung und der Trägerplatte auftritt.

Die bei den erfindungsgemäßen Reaktionskammern verwendete Durchführung besteht aus zwei "Hauptelementen", nämlich der Trägerplatte und der wenigstens einen in die Trägerplatte eingesetzten HF-Leitung. Beide Teile sind gegeneinander isoliert und können damit aus einem Metall bestehen, so daß sie nicht bruchempfindlich sind. Die HF-Leitung ist dabei mit der Trägerplatte verschraubt, wobei die Schraubverbindung, beispielsweise eine Überwurfmutter, so gestaltet ist, daß keine wesentlichen Kräfte auf bruchempfindliche Materialien, wie beispielsweise Elemente aus isolierendem Material ausgeübt werden, auch wenn Schläge bzw. Stöße auf die HF-Leitung und/oder die Trägerplatte wirkten. Dies wird insbesondere dadurch erreicht, daß die Isolierung zwischen der HF-Leitung und der Trägerplatte durch eine isolierenden Scheibe hergestellt wird, die beispielsweise aus Quarz oder einem Keramikmaterial besteht. Eine derartige Scheibe ist vergleichsweise unempfindlich gegen Brüche etc. Sollte dennoch einmal eine Beschädigung der isolierenden Scheibe und/oder von Dichtungen, die insbesondere O-Ringe sein können, auftreten, so können diese Teile nach Lösen der Verbindungen und insbesondere der Schraubverbindung zwischen HF-Leitung und Trägerplatte leicht ausgetauscht werden.

Das Schraubelement kann aus einem isolierenden Material bestehen; bevorzugt ist es jedoch, wenn es aus einem Metall, wie Stahl bzw. Edelstahl, besteht, und wenn zwischen das Schraubelement und die Trägerplatte eine zweite Scheibe aus einem isolierenden Material eingesetzt ist, die ebenfalls bevorzugt aus Quarz oder einem Keramikmaterial besteht

Um einen elektrischen Kontakt oder Überschläge zwischen der HF-Leitung und der beispielsweise aus Edelstahl bestehenden Trägerplatte zu verhindern, ist es weiterhin bevorzugt, wenn zwischen die erste Scheibe und die zweite Scheibe bzw. das Schraubelement eine Hülse aus einem isolierenden Material eingesetzt ist. Diese Hülse, auf die unter Umständen Kräfte wirken können, die aber zur Abdichtung keinen Beitrag leistet, besteht bevorzugt aus einem isolierenden Kunststoff und insbesondere Teflon.

Insbesondere dann, wenn große elektrische Leistungen in die Reaktionskammer übertragen werden sollen, ist es von Vorteil, wenn die Trägerplatte wassergekühlt ist. Hierzu können wasserdurchströmte Kanäle in der Trägerplatte vorgesehen sein. Dabei ist es von besonderem Vorteil, wenn jede HF-Leitung von einem wasserdurchströmten Kanal umgeben ist.

Bei einer bevorzugten Ausgestaltung der Erfindung ist der Kragen Bestandteil einer Hülse, die an der HF-Leitung dichtend angebracht ist, und an deren anderem Ende das Gewinde vorgesehen ist.

Im Hinblick auf die elektrische und thermische Leitfähigkeit ist es ferner bevorzugt, wenn die HF-Leitung aus Kupfer besteht. Der Kragen kann dann aus einem (anderen) metallischen Material und insbesondere Edelstahl bestehen und auf die HF-Leitung aufgelötet sein.

Zur Herstellung einer dichten Verbindung zwischen der Außenwand der Reaktionskammer und der Trägerplatte ist es ferner von Vorteil, wenn die Trägerplatte eine außen liegende Dichtung aufweist, und in dem Bereich innerhalb der Dichtung mit der Wand der Reaktionskammer verschraubt ist.

Bei einem bevorzugten Ausführungsbeispiel der Erfindung sind in der (jeder) Trägerplatte wenigstens zwei Leitungen und insbesondere HF-Leitungen vorgesehen, die insbesondere die Zuleitungen für eine Spule einer induktiven Heizung sein können.

### Kurze Beschreibung der Zeichnung

Die Erfindung wird nachstehend ohne Beschränkung des allgemeinen Erfindungsgedankens anhand eines Ausführungsbeispiels unter Bezugnahme auf die Zeichnung exemplarisch beschrieben, auf die im übrigen hinsichtlich der Offenbarung aller im Text nicht näher erläuterten erfindungsgemäßen Einzelheiten ausdrücklich verwiesen wird. Es zeigt:

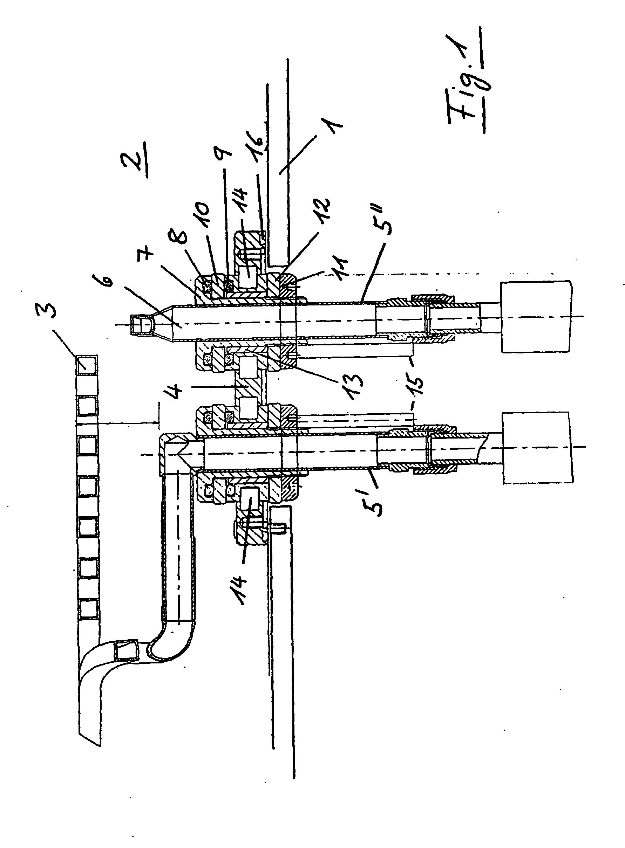

- Fig. 1: einem Querschnitt durch einen Teil einer erfindungsgemäßen Reaktionskammer.

### Beschreibung eines Ausführungsbeispiels

Fig. 1 zeigt einem Querschnitt durch ein Teil einer erfindungsgemäßen Reaktionskammer, von der nur eine Außenwand 1 dargestellt ist. In der Außenwand 1 ist ein Durchbruch (ohne Bezugszeichen) vorgesehen, in die die erfindungsgemäß ausgebildete HF-Durchführung eingesetzt ist. Die HF-Durchführung ist im Innenraum 2 der Reaktionskammer mit einer Induktionsspule 3 verbunden. Selbstverständlich kann der die erfindungsgemäße Durchführung auch andere in der Reaktionskammer angeordnete Elemente mit elektrischem Strom versorgen.

Die erfindungsgemäße Durchführung weist eine beispielsweise aus Edelstahl bestehende Trägerplatte 4 auf, die bei dem gezeigten Ausführungsbeispiel zwei Durchbrüche für HF-Leitungen 5' und 5" aufweist, die mit der Induktionsspule 3 verbunden sind. Die HF-Leitungen 5 bestehen aus Kupfer und weisen in ihrem Inneren einen wasserdurchströmten Kanal 6 auf. An jeder der Leitungen 5 ist eine Hülse 7 mit einem Kragen an dem im Innenraum 2 der Reaktionskammer angeordneten Ende und mit einem Außengewinde auf dem außerhalb der Reaktionskammer befindlichen Ende vorgesehen. Auf der Unterseite des Kragens der Hülse 7 ist eine Nut vorgesehen, in die ein O-Ring 8 eingelegt ist. Auch auf der Oberseite der Trägerplatte 4 ist eine Nut vorgesehen, in die ein O-Ring 9 eingelegt ist. Zwischen dem Kragen 7 und der Trägerplatte 4 ist eine Scheibe 10 aus einem isolierenden Material, bevorzugt Quarz oder einem Keramikmaterial, angeordnet.

Um die Dichtungen 8 und 9 im dichtender Anlage an der Scheibe 10 zu halten, ist auf das Außengewinde auf dem anderen Ende der Hülse 7 eine Überwurfmutter 11 aufgeschraubt, die elektrisch von der Trägerplatte 4 durch eine Scheibe 12 aus einem isolierenden Material, beispielsweise ebenfalls Quarz oder ein Keramikmaterial, getrennt ist. Um Überschläge zwischen der Hülse 7 und der Trägerplatte 4 zu vermeiden, ist in den Zwischenraum eine Hülse 13 eingesetzt, die ebenfalls aus einem isolierenden Material, bevorzugt einem Kunststoffmaterial, wie Teflon besteht.

Zur Kühlung der Trägerplatte 4 sind in dieser Kanäle 14 vorgesehen, durch die über Anschlüsse 15 Wasser geleitet wird.

Auf der der Außenwand 1 zugewandten Seite der Trägerplatte 4 ist im äußeren Randbereich eine Nut vorgesehen, in die ein O-Ring 16 eingelegt ist. Durch eine in der Zeichnung angedeutete Schraubverbindung wird die Trägerplatte 4 dichtend an die Wand 1 angepreßt.

Ferner sind in der Zeichnung Sicherungsschrauben sowie ein Anschluß für eine Wasser-Zu- und Ableitung zu erkennen. Dieser Anschluß kann beispielsweise mittels einer Rohrverschraubung realisiert werden.

Vorstehend ist die Erfindung anhand eines Ausführungsbeispiels ohne Beschränkung der Allgemeinheit beschrieben worden. Insbesondere ist die dargestellte geometrische Realisierung lediglich als Beispiel zu verstehen.

## Patentansprüche

1. Reaktionskammer insbesondere für die Durchführung von Verfahren zur Beschichtung von Substraten, wie CVD-Verfahren, bei der in wenigstens einer Außenwand mindestens ein Durchbruch vorgesehen ist, in die druck- bzw. vakuumdicht eine HF- und insbesondere RF-Durchführung eingesetzt ist,
**gekennzeichnet durch** die Kombination folgender Merkmale:
- in jeden Durchbruch ist eine Trägerplatte (4) dichtend eingesetzt,
- die Trägerplatte weist wenigstens einen Durchbruch für eine HF-Leitung (5) auf,
- jede HF-Leitung weist an ihrem in der Reaktionskammer angeordneten Bereich einen Kragen auf, an dem eine erste Dichtung (8) vorgesehen ist,
- zwischen eine zweite Dichtung (9) an der Trägerplatte (4) und die erste Dichtung (8) an dem Kragen ist eine erste Scheibe (10) aus einem isolierenden Material eingesetzt,
- an dem außerhalb der Reaktionskammer angeordneten Bereich jeder HF-Leitung ist ein Gewinde vorgesehen, auf das ein Schraubelement (11) derart aufgeschraubt ist, daß es den Kragen der HF-Leitung über die erste Dichtung an der isolierenden Scheibe und diese über die zweite Dichtung an der Trägerplatte dichtend in Anlage hält, ohne daß ein elektrischer Kontakt zwischen HF-Leitung und Trägerplatte besteht bzw. ein Überschlag zwischen der HF-Leitung und der Trägerplatte auftritt.

2. Reaktionskammer nach Anspruch 1,
**dadurch gekennzeichnet, daß** das Schraubelement (11) aus einem Metall besteht, und
daß zwischen das Schraubelement (11) und die Trägerplatte (4) eine zweite Scheibe (12) aus einem isolierenden Material eingesetzt ist.

3. Reaktionskammer nach Anspruch 1 oder 2,
**dadurch gekennzeichnet, daß** zwischen die erste Scheibe (10) und die zweite Scheibe (12) bzw. das Schraubelement (11) eine Hülse (13) aus einem isolierenden Material eingesetzt ist, die einen elektrischen Kontakt bzw. einen Überschlag zwischen der HF-Leitung (5) und der Trägerplatte (4) verhindert.

4. Reaktionskammer nach einem der Ansprüche 1 bis 3,
**dadurch gekennzeichnet, daß** das Schraubelement eine Überwurfmutter (11) ist.

5. Reaktionskammer nach einem der Ansprüche 1 bis 4,
**dadurch gekennzeichnet, daß** die Trägerplatte wassergekühlt ist.

6. Reaktionskammer nach einem der Ansprüche 2 bis 5,
**dadurch gekennzeichnet, daß** die erste und die zweite Scheibe (10,12) aus Quarz oder einem keramischen Material bestehen.

7. Reaktionskammer nach einem der Ansprüche 3 bis 6,
**dadurch gekennzeichnet, daß** die Hülse (13) aus einem isolierenden Kunststoff und insbesondere Teflon besteht.

8. Reaktionskammer nach einem der Ansprüche 1 bis 7,
**dadurch gekennzeichnet, daß** der Kragen Bestandteil einer Hülse (7) ist, die an der HF-Leitung (5) dichtend angebracht ist, und an deren anderem Ende das Gewinde vorgesehen ist.

9. Reaktionskammer nach einem der Ansprüche 1 bis 8,
**dadurch gekennzeichnet, daß** die HF-Leitung (5) aus Kupfer besteht.

10. Reaktionskammer nach Anspruch 9,
**dadurch gekennzeichnet, daß** der Kragen bzw. die Hülse (7) aus einem metallischen Material und insbesondere Edelstahl besteht und auf die HF-Leitung aufgelötet ist.

11. Reaktionskammer nach einem der Ansprüche 1 bis 10,
**dadurch gekennzeichnet, daß** die Trägerplatte (4) eine außen an ihrem Umfang liegende Dichtung (16) aufweist, und in dem Bereich innerhalb der Dichtung mit der Wand (1) der Reaktionskammer verschraubt ist.

12. Reaktionskammer nach einem der Ansprüche 1 bis 11,
**dadurch gekennzeichnet, daß** die Dichtungen (8,9,16) O-Ringe sind.

13. Reaktionskammer nach einem der Ansprüche 1 bis 12,
**dadurch gekennzeichnet, daß** in der Trägerplatte (4) wenigstens zwei HF-Leitungen (5', 5") vorgesehen sind.

14. Reaktionskammer nach Anspruch 13,
**dadurch gekennzeichnet, daß** die beiden HF-Leitungen (5', 5") die Zuleitungen für eine Spule (3) einer induktiven Heizung sind.

15. Reaktionskammer nach Anspruch 13 oder 14,
**dadurch gekennzeichnet, daß** eine Wasserkühlung wasserdurchströmte Kanäle (14) in der Trägerplatte (4) aufweist.

16. Reaktionskammer nach Anspruch 15,
**dadurch gekennzeichnet, daß** jede HF-Leitung (5', 5") von einem wasserdurchströmten Kanal (14) umgeben ist.

## Claims

1. A reaction chamber especially for carrying out substrate coating methods, such as CVD methods, in which at least one opening in which an HF feedthrough, and especially an RF feedthrough, is inserted in a pressure- and vacuum-tight manner is provided in at least one outside wall, **characterized by** the combination of the following features:
- a support plate (4) is inserted in a sealing manner into every opening,
- the support plate has at least one opening for an HF line (5),
- every HF line has at its region disposed in the reaction chamber a collar on which a first seal (8) is provided,
- a first disk (10) of an insulating material is inserted between a second seal (9) on the support plate (4) and the first seal (8) on the collar,
- at the region of each HF line disposed outside the reaction chamber there is provided a thread onto which a screw element (11) is screwed in such a way that it holds the collar of the HF line in a sealing manner against the insulating disk via the first seal and said disk against the support plate via the second seal, without an electrical contact between the HF line and the support plate being established or an arc-over between the HF line and the support plate occurring.

2. The reaction chamber as claimed in claim 1, **characterized in that** the screw element (11) consists of a metal, and **in that** a second disk (12) of an insulating material is inserted between the screw element (11) and the support plate (4).

3. The reaction chamber as claimed in claim 1 or 2, **characterized in that** a sleeve (13) of an insulating material which prevents electrical contact or arc-over between the HF line (5) and the support plate (4) is inserted between the first disk (10) and the second disk (12) or the screw element (11).

4. The reaction chamber as claimed in one of claims 1 to 3, **characterized in that** the screw element is a union nut (11).

5. The reaction chamber as claimed in one of claims 1 to 4, **characterized in that** the support plate is water-cooled.

6. The reaction chamber as claimed in one of claims 2 to 5, **characterized in that** the first and the second disk (10, 12) consist of quartz or a ceramic material.

7. The reaction chamber as claimed in one of claims 3 to 6, **characterized in that** the sleeve (13) consists of an insulating plastic and especially Teflon.

8. The reaction chamber as claimed in one of claims 1 to 7, **characterized in that** the collar is a component part of a sleeve (7) which is mounted in a sealing manner on the HF line (5), and at the other end of which the thread is provided.

9. The reaction chamber as claimed in one of claims 1 to 8, **characterized in that** the HF line (5) consists of copper.

10. The reaction chamber as claimed in claim 9, **characterized in that** the collar or the sleeve (7) consists of a metallic material and especially stainless steel and is soldered on to the HF line.

11. The reaction chamber as claimed in one of claims 1 to 10, **characterized in that** the support plate (4) has a seal (16) lying externally on its circumference, and is screwed to the wall (1) of the reaction chamber in the region inside the seal.

12. The reaction chamber as claimed in one of claims 1 to 11, **characterized in that** the seals (8, 9, 16) are O-rings.

13. The reaction chamber as claimed in one of claims 1 to 12, **characterized in that** at least two HF lines (5', 5") are provided in the support plate (4).

14. The reaction chamber as claimed in claim 13, **characterized in that** the two HF lines (5', 5") are the leads for a coil (3) of an inductive heater.

15. The reaction chamber as claimed in claim 13 or 14, **characterized in that** a water cooling has channels (14) through which water flows in the support plate (4).

16. The reaction chamber as claimed in claim 15, **characterized in that** every HF line (5', 5") is surrounded by a channel (14) through which water flows.

## Revendications

1. Chambre de réaction destinée notamment à mettre en oeuvre des procédés de revêtement de substrats, tels que des procédés CVD, dans laquelle il est ménagé, dans au moins une paroi extérieure, au moins un passage, dans lequel est insérée une ligne HF, et en particulier RF, de façon étanche à la pression respectivement à la dépression,
**caractérisée par** la combinaison des caractéristiques suivantes :
- une plaque de support (4) est insérée de façon étanche dans chaque passage,
- la plaque de support comporte au moins un passage destiné à une ligne HF (5),
- chaque ligne HF comporte, au niveau de sa région située dans la chambre de réaction, une collerette sur laquelle il est prévu un premier joint d'étanchéité (8),
- une première rondelle (10) en matériau isolant est insérée entre le premier joint d'étanchéité (8) situé au niveau de la collerette et un deuxième joint d'étanchéité (9) situé au niveau de la plaque de support (4),
- un filetage est prévu dans la région de chaque ligne HF située à l'extérieur de la chambre de réaction, un élément fileté (11) étant vissé dans le filetage de manière à maintenir en position étanche la collerette de la ligne HF sur le premier joint d'étanchéité au niveau de la rondelle isolante et cette rondelle isolante sur le deuxième joint d'étanchéité au niveau de la plaque de support sans former de contact électrique entre la ligne HF et la plaque de support ou respectivement sans qu'une décharge apparaisse entre la ligne HF et la plaque de support.

2. Chambre de réaction selon la revendication 1, **caractérisée en ce que** l'élément fileté (11) est en métal, et **en ce qu'**une deuxième rondelle (12) en matériau isolant est insérée entre l'élément fileté (11) et la plaque de support (4).

3. Chambre de réaction selon la revendication 1 ou 2, **caractérisée en ce qu'**un manchon (13) en matériau isolant, empêchant un contact électrique ou respectivement une décharge entre la ligne HF (5) et la plaque de support (4), est inséré entre la première rondelle (10) et la deuxième rondelle (12) ou respectivement l'élément fileté (11).

4. Chambre de réaction selon l'une des revendications 1 à 3, **caractérisée en ce que** l'élément fileté est un écrou d'accouplement (11).

5. Chambre de réaction selon l'une des revendications 1 à 4, **caractérisée en ce que** la plaque de support est refroidie à l'eau.

6. Chambre de réaction selon l'une des revendications 2 à 5, **caractérisée en ce que** les première et deuxième rondelles (10, 12) sont en quartz ou en matériau céramique.

7. Chambre de réaction selon l'une des revendications 3 à 6, **caractérisée en ce que** le manchon (13) est en matière plastique isolante et en particulier en téflon.

8. Chambre de réaction selon l'une des revendications 1 à 7, **caractérisée en ce que** la collerette fait partie d'un manchon (7), monté de façon étanche sur la ligne HF (5) et à l'extrémité duquel est prévu le filetage.

9. Chambre de réaction selon l'une des revendications 1 à 8, **caractérisée en ce que** la ligne HF (5) est en cuivre.

10. Chambre de réaction selon la revendication 9, **caractérisée en ce que** la collerette ou respectivement le manchon (7) est en matériau métallique et en particulier en acier fin et est brasée sur la ligne HF.

11. Chambre de réaction selon l'une des revendications 1 à 10, **caractérisée en ce que** la plaque de support (4) comporte à sa périphérie un joint d'étanchéité (16) externe et est vissée à la paroi (1) de la chambre de réaction, dans la région se trouvant à l'intérieur du joint d'étanchéité.

12. Chambre de réaction selon l'une des revendications 1 à 11, **caractérisée en ce que** les joints d'étanchéité (8, 9, 16) sont des joints toriques.

13. Chambre de réaction selon l'une des revendications 1 à 12, **caractérisée en ce qu'**au moins deux lignes HF (5', 5") sont prévues dans la plaque de support (4).

14. Chambre de réaction selon la revendication 13, **caractérisée en ce que** les deux lignes HF (5', 5") sont les lignes d'alimentation d'une bobine (3) d'un chauffage inductif.

15. Chambre de réaction selon la revendication 13 ou 14, **caractérisée en ce que** le dispositif de refroidissement par eau comporte des canaux de circulation d'eau (14) ménagés dans la plaque de support (4).

16. Chambre de réaction selon la revendication 15, **caractérisée en ce que** chaque ligne HF (5', 5") est entourée par un canal de circulation d'eau (14).
